# EUROPEAN PATENT APPLICATION

(11) **EP 2 947 412 A1**
(43) Date of publication of application: **25.11.2015**
(21) Application number: 14740287.9
(22) Date of filing: 17.01.2014
(51) Int. Cl.: F28F 3/12, F28F 3/08, F28F 3/10, F28F 21/08

(54) **HEAT EXCHANGER AND METHOD FOR MANUFACTURING SAME**

(30) Priority: 18.01.2013 JP 2013007892
(71) Applicant: Taisei Plas Co., Ltd., Tokyo 103-0007 (JP)
(72) Inventor: NARITOMI, Masanori, Tokyo 103-0023 (JP); OGAWA, Noritaka, Tokyo 103-0023 (JP)
(74) Representative: Ter Meer Steinmeister & Partner
(86) International application number: PCT/JP2014/050845
(87) International publication number: WO 2014/112600

(57) **Abstract**

In the present invention, the manufacturing process is simplified, the weight and cost are reduced, and a safe and reliable structure is produced by using a generic metal plate. In a heat exchanger according to the present invention, thin metal plates of a predetermined thickness, which have outer surfaces 4a, 5a that are to be positioned on the side of electronic components 3 - objects of heat exchange -, and which have resin-coated inner surfaces 4b, 5b, are press-worked to a predetermined shape, whereby a first molded body 4 and a second molded body 5 are formed. The two molded bodies are combined so that the inner surfaces 4b, 5b thereof face each other, and the inner surface 4c at the edge portion 4c and the inner surface 5b at the edge portion 5c are thermally fused together by hot press-working. The edge portions 4c, 5c are performed to ultrafine processing and then inserted into a die, and a thermoplastic resin composition is injected into the cavity of the die, whereby a joining member 6 is molded. A space 7 created by the combining has a supply port 10 and a discharge port 11 and serves as a fluid passage for a heat medium 8. A heat exchanger 1 has such a structure, the outer surfaces 4a, 5a are brought into contact with electronic components 3, and heat exchange is performed with the heat medium flowing through the fluid passage.

## Description

### TECHNICAL FIELD

The present invention relates to a heat exchanger that performs heat exchange through a heat medium and to a method for manufacturing the heat exchanger. More specifically, the present invention relates to a heat exchanger implementing cooling by performing heat exchange with, for example, an electronic component of an electronic control circuit and to a method for manufacturing the same.

### BACKGROUND ART

Heat exchangers of various structures in which heat is efficiently moved from one physical body to another have been suggested for heating and cooling and used in a variety of field. In particular, in the field of cooling devices for electronic components, since semiconductor elements, such as CPU which are installed on a substrate of a control circuit, generate a large amount of heat, such semiconductor elements need to be cooled, and cooling units are provided therefor. For example, electronic components in the automotive filed in which coolers of air cooling system or water cooling system are used are often placed under a harsh environment when an automobile is driven in a high temperature desert area or in a cold region.

In the automotive filed, functions of electronic components installed in the automobiles need to be maintained in a normal state at all times even under such adverse environment. Since failure to maintain the normal state of electronic components constituting control circuits can result in major accidents, an abnormal state should be avoided by all means. In particular, since electronic components and electronic circuits in the automotive field relate to human life, they need to operate reliably and safely. Weight reduction is another problem associated with the automobile-related parts and devices.

This is because when the weight of a cooling device that cools electronic components is heavy, for example, fuel consumption is affected and fuel efficiency is decreased. For this reason, all of the components for use in automobiles have recently become the objects of weight reduction. The weight reduction also contributes to cost reduction. Therefore, weight reduction is also required for automotive cooling devices, and the increase in cooling efficiency is also needed. For those reasons, aluminum alloys have recently been used for base members of cooling devices.

For example, it is well known that aluminum alloys which are used for cooling engine systems of automobiles have already been used for a long time as materials therefor. However, joining between the aluminum alloy components is performed by brazing using Al-Si system brazing alloys. Cooling devices made from aluminum alloys joined by brazing have also recently been put to use as the main constituent members for cooling in cooling of electronic components on control circuit boards. A cooling device in which a base plate integrated with the cooling device is configured by a molded member has been disclosed as an example of the abovementioned cooling device for use, for example, in a switching power supply apparatus (see, for example, Patent Documents 1 and 2).

The base plate constituting the frame body of the cooling device is brought into contact with electronic components mounted on an electronic circuit board and performs cooling by heat conduction. For this reason, the base plate has a flat rectangular shape matching the shape of the electronic circuit board. The specific feature of the disclosed example is that the cooling device does not have an independent structure. Instead, the base plate is brought into direct contact with the electronic component to increase heat exchange and miniaturize the base plate. The integrated structure is obtained by providing the cooling device in a recess in the base plate. In this structure, the height of pedestals is changed according to the difference in height between the electronic components in order to enable the area of contact therewith.

An example of using a thin metal body for a cooling is also known (see, for example, Patent Document 3). In this example, a cooling device is disclosed in which two press-molded plates are joined to obtain a tubular shape and fins are arranged inside the tube. A structure including a plurality of such tubes is disclosed in which the tubes are stacked at a predetermined interval in a direction perpendicular to the flow direction of a cooling fluid. The tube thickness is indicated to be 0.4 mm and the tube can be deformed to a certain extent. However, although an aluminum alloy is also used as a material in all of the above-described examples to reduce weight, brazing, which is the conventional method for adherence, has been mainly used for joining the aluminum alloy components to each other.

Since brazing in the automotive field lacks reliability, various measures have been implemented and certain suggestions have been made to improve resistance to a harsh environment, but none of them seems to be perfect. Techniques, members, and devices that have been established in other industrial fields can be also effectively considered when examining weight and cost reduction. In particular, a can body which has been used as a thin-wall metal body for typical canned beer uses a thin-sheet aluminum alloy coil body with a thickness equal to or less than 0.1 mm (see, for example, Patent Documents 4 and 5). Such a thin aluminum alloy coil body which is used as a material for can body has a laminated structure in which the alloy surface is coated with a resin film, and pressing and drawing can be performed even in such resin-coated state.

The aluminum alloy coil body is disclosed to be suitable for molding DI cans or bottle cans. The aluminum alloy coil body is a very thin material and, therefore, can be easily bent and deformed. Further, the resin coating film prevents the metal from contact with water and also has gas-barrier ability such that prevents beer from oxidation. Furthermore, joining techniques that excel in weight reduction and bonding strength have been established for joining aluminum alloys and resins (see, for example, Patent Documents 6 and 7). Thus, with one technique, an aluminum alloy surface is performed to chemical etching to form an ultrafine uneven surface, and a thermoplastic resin composition is bonded to the ultrafine uneven surface by injection molding. As a result, the metal surface and the resin are strongly adhered to each other. A method is also known for obtaining a box-shaped metal structure by bringing the edge portions of two aluminum alloy sheets, which have been treated by the aforementioned technique and have a bent shape, into intimate contact with each other and adhering the edge portions to each other by injection molding by the same method as described hereinabove (see, for example, Patent Document 8).
Patent Document 1: Japanese Patent Application Publication No. 2012-210002
Patent Document 2: Japanese Patent Application Publication No. 2004-297887
Patent Document 3: Japanese Patent Application Publication No. 2005-203732
Patent Document 4: Japanese Patent Application Publication No. H09-277434
Patent Document 5: Japanese Patent Application Publication No. 2011-208258
Patent Document 6: Japanese Patent Application Publication No. 2009-101563
Patent Document 7: WO 2009/031632
Patent Document 8: Japanese Patent Application Publication No. 2010-30298

### DISCLOSURE OF THE INVENTION

However, although the weight of the above-described conventional heat exchangers has been reduced by using aluminum alloys, structures thereof still leave room for improvement in terms of weight and cost reduction. Thus, the base body serving as a base is a member obtained by molding an aluminum alloy and therefore is an aluminum alloy body having a certain thickness. Since the base body is an aluminum alloy molded member, the structure obviously has a certain thickness.

Since there is a limit to reduction of a molded member in thickness, possible weight reduction thereof is also limited. Further, as mentioned hereinabove, a cooling device with a tubular configuration has also been suggested as a structure enabling weight reduction. This structure is obtained by press-molding an aluminum alloy in the form of a thin sheet material and arranging fins inside the molded body. However, although the thickness is rather thin, there is still room for thickness reduction. In addition, such a structure is complex and costly as a cooling device structure. A thin metal sheet using as a material for the tube has a thickness of 0.4 mm, but although it can be deformed to a certain degree, it is not a material of a thickness such that part of the material is locally bent in response to an internal pressure from a liquid heat medium, such as water, located inside thereof.

Thus, although the conventional structures enable certain weight reduction, further reduction in weight and cost poses difficulties. Yet another problem is that brazing is used for joining the aluminum alloys. The aforementioned tube has a structure in which two plates are overlapped, and the overlapping portions are brazed. With the braze joining method, the joined state can become imperfect, for example, corrosion or joining defects can occur, due to vibrations, or the like, under a harsh usage environment. In particular, in the case of cooling devices for automobiles, since vibrations are an ever-present factor, water serving as a heat medium can leak in the case of fracture, and the devices are not necessarily reliable. Further, salt damage caused by freezing-preventing agents sprayed on the road in cold climates and salt damage in seaside or coastal areas are also a problem.

Structures in which cooling is performed by contact with semiconductor elements in an automobile, which are heat-generating bodies, need to be fully resistance to vibrations and thermal fluctuation in the automobile which can occur, as mentioned hereinabove, under a severe environment. Thus, a structure is required in which joints do not separate due to corrosion, or the like. Further, cooling performed by direct contact with semiconductor elements, as mentioned hereinabove, is effective because the structure ensures direct cooling. However, the cooling space is narrowed, and it is presently difficult to introduce changes aimed to expand the cooling space in order to increase further the cooling effect. Thus, at present, the cooling style is structurally limited and the cooling efficiency remains decreased.

In particular, in a stacked arrangement of a plurality of semiconductor elements and cooling devices, a large amount of heat is generated, and therefore further increase in cooling efficiency is required. As mentioned hereinabove, where the temperature of electronic components of semiconductor elements, rises, functions of the elements are disrupted. In the cooling systems for such applications, water cooling, which produces a better cooling effect than air cooling, has been used. Furthermore, with consideration for cold climates, it is preferred that cooling be performed with cooling water such as a non-freezing solution. It is considered to be ideal that the temperature of semiconductor elements be kept equal to or less than 70°C by implementing such cooling measures.

The present invention has been created in view of the above-described technical background and attains the below-described objective.

The objective of the present invention is to provide a safe and reliable heat exchanger which has a simple structure and enables weight and cost reduction and also provide a method for manufacturing the heat exchanger.

The present invention employs the following means to attain the aforementioned objective.

A heat exchanger according to the present invention 1 is a heat exchanger for exchanging heat with a heat exchange object (3) through a heat medium (8), the heat exchanger comprising:
a first molded body (4) which comprises a thin metal sheet that can be bent by an internal pressure of the heat medium (8), and which comprises an outer surface (4a) that can contact with the heat exchange object and an inner surface (4b) coated with a resin, and an edge portion formed on a periphery and a recess formed in a concave cross-sectional shape between the edge portions;
a second molded body (5) which is a member facing the first molded body (4) and combined therewith, comprises a thin metal sheet that can be bent by an internal pressure of the heat medium (8), and which comprises an outer surface (5a) that can contact with the heat exchange object and an inner surface (5b) coated with a resin, and an edge portion formed on a periphery and a recess formed in a concave cross-sectional shape between the edge portions;
a joining member (6) which is provided to straddle the edge portion (4c) of the first molded body (4) and the edge portion (5c) of the second molded body (5), which are abutted against each other, the joining member integrally joining the edge portion of the first molded body and the edge portion of the second molded body by performing injection molding using a thermoplastic resin composition on the outer surface (4a) of the edge portion of the first molded body and on the outer surface (5a) of the edge portion of the second molded body; and
a space (7) as a fluid passage for the heat medium (8) which is surrounded and formed by the first molded body and the second molded body which are integrally joined by the joining member, and a supply port (10) and a discharge port (11), wherein
the inner surface (4b) of the edge portion (4c) of the first molded body and the inner surface (5b) of the edge portion (5c) of the second molded body are brought into intimate contact with each other by thermally fusing the resins coated thereupon, thereby sealing the space.

A heat exchanger according to the present invention 2 is the heat exchanger according to the present invention 1, wherein the thin metal sheet is an aluminum alloy sheet of a predetermined thickness that is coated with the resin.

A heat exchanger according to the present invention 3 is the heat exchanger according to the present invention 1 or 2, wherein the heat exchange object is an electronic component installed on an electronic control circuit board of an automobile, and a main component of the heat medium is cooling water.

A heat exchanger according to the present invention 4 is the heat exchanger according to the present invention 1 or 2, wherein the outer surface (4a) of the first molded body and the outer surface (5a) of the second molded body, to which the thermoplastic resin composition is adhered by the injection molding, is performed to ultrafine processing to strengthen the adherence of the thermoplastic resin composition, and the thermoplastic resin composition comprises one selected from a polybutylene terephthalate resin, a polyphenylene sulfide resin, and a polyamide resin as a main component.

A heat exchanger according to the present invention 5 is the heat exchanger according to the present invention 1 or 2, wherein projecting portions (14, 15) of protruding shapes that project to the space (7) side are provided at parts of the shape of the recess in the first molded body (4) and/or the second molded body (5) to cause the heat medium to meander.

A heat exchanger according to the present invention 6 is the heat exchanger according to the present invention 1 or 2, wherein projecting portions of protruding shapes that project to the electronic component side are provided at parts of the shape of the recess in the first molded body and/or the second molded body.

A heat exchanger according to the present invention 7 is the heat exchanger according to the present invention 1 or 2, wherein parts of the shape of the recess are protruded and depressed and steps matching the height of the electronic components are provided in the first molded body and/or the second molded body.

A heat exchanger according to the present invention 8 is the heat exchanger according to the present invention 1 or 2, wherein the bendable thin metal sheet is a metal sheet of an aluminum alloy with a thickness of 0.1 mm to 0.8 mm.

A heat exchanger according to the present invention 9 is the heat exchanger according to the present invention 1 or 2, wherein heat exchange enhancing bodies that are in surface contact with the first molded body and the second molded body and enhance heat exchange are enclosed in the space.

A method for manufacturing a heat exchanger according to the present invention 10 is
a method for manufacturing a heat exchanger for exchanging heat with a heat exchange object (3) through a heat medium (8), the method comprising:
   a process for press-molding two thin bendable metal sheets coated with a resin on surfaces on one side thereof into a first molded body (4) and a second molded body (5), which have, respectively, outer surfaces (4a, 5a) that are to be in contact with the heat exchange objects (3) and inner surfaces (4b, 5b) that are resin-coated surfaces which are coated with the resin, an edge portion formed on a periphery and a recess formed in a concave cross-sectional shape between the edge portions;
   a process for combining the first molded body (4) and the second molded body (5) such that the inner surface (4b) of the former and the inner surface (5b) of the latter face each other, thereby forming a space (7) that serves as a flow channel for the heat medium (8), and thermally fusing the resin-coated surface of the edge portion (4c) of the first molded body and the resin-coated surface of the edge portion (5c) of the second molded body by hot press working;
   an injection molding process for inserting the first molded body (4) and the second molded body (5), which are thermally fused, into a die (12), injecting a thermoplastic resin composition into cavities (12d) formed in regions of the edge portions (4c, 5c), and forming a joining member (6) that joins integrally the first molded body and the second molded body; and
   a process for providing the first molded body and the second molded body, which are joined by the joining member, with a supply port (10) and a discharge port (11) communicating with the space (7).

A method for manufacturing a heat exchanger according to the present invention 11 is the method for manufacturing a heat exchanger according to the present invention 10, wherein the thin metal sheet is an aluminum alloy sheet of a predetermined thickness that is coated with the thermoplastic resin composition comprises one selected from a polybutylene terephthalate resin, a polyphenylene sulfide resin, and a polyamide resin as a main component; and the method comprises a process for performing the outer surface (4a) of the first molded body (4) and the outer surface (5a) of the second molded body (5) to ultrafine processing to strengthen the adherence of the thermoplastic resin composition before the injection molding.

A method for manufacturing a heat exchanger according to the present invention 12 is the method for manufacturing a heat exchanger according to the present invention 10 or 11, wherein the process for press-molding comprises a process for molding projecting portions that project in a protruding shape in parts of the shape of the recess of the first molded body (4) and/or the second molded body (5) in order to cause the heat medium to meander.

The method for manufacturing a heat exchanger according to the present invention 13 is the method for manufacturing a heat exchanger according to the present invention 10 or 11, wherein the process for press-molding comprises a process for molding step shapes in parts of the shape of the recess of the first molded body (4) and/or the second molded body (5).

In the heat exchanger in accordance with the present invention, the base body of the heat exchanger is a molded body of a thin metal sheet. Therefore, the heat exchanger in which two molded bodies are combined has a structure that can be easily bendable and partially deformable. The outer surfaces of the edge portions of the two molded bodies are performed to ultrafine surface processing providing a fine uneven surface thereon, a thermoplastic resin composition is injected onto those regions, and a joining member is molded that joins the periphery of the edge portions of the two molded bodies in a sandwiched state. The resultant strong joining makes it possible to obtain a highly reliable high-quality heat exchanger in which the heat medium does not leak to the outside from the space serving as the flow channel for the heat medium, even under the effect of vibrations of an automobile.

Further, the resins coated on the inner surface of the edge portions of the two molded bodies are thermally fused by hot press working and the inner surfaces of the edge portions are sealed. The double-seal structure obtained by sealing with the joining member and sealing by thermal fusion of the resins on the inner surfaces makes it possible to obtain a highly reliable high-quality heat exchanger in which the heat medium does not leak to the outside from the space. Further, since such heat exchanger does not use brazing performed with a braze, product reliability is improved.

The method for manufacturing a heat exchanger in accordance with the present invention is a high-productivity manufacturing method that comprises a press-molding process, a hot pressing process, and an injection molding process as the main processes and makes it possible to manufacture a highly reliable high-quality heat exchanger at a low cost and with good productivity.

### BRIEF DESCRIPTION OF THE DRAWINGS

FIG. 1 is a cross-sectional view illustrating a state in which electronic components are brought into contact with one molded body of a heat exchanger of a unitary structure to perform heat exchange.
FIGS. 2(a) to 2(e) are explanatory process diagrams illustrating the process for manufacturing a heat exchanger.
FIG. 3 is a cross-sectional view illustrating a state in which electronic components mounted on two boards are brought into contact with two molded bodies of a heat exchanger of a unitary structure to perform heat exchange.
FIG. 4 is a cross-sectional view illustrating a state in which a plurality of heat exchangers is arranged side by side and a plurality of electronic components mounted on a plurality of boards are brought into contact therewith to perform heat exchange.
FIG. 5 is a cross-sectional view illustrating a state in which uneven steps are provided in one molded body of a heat exchanger, and electronic components are brought into contact therewith to perform heat exchange.
FIG. 6 is a cross-sectional view illustrating a state in which convex projecting portions are provided at one molded body, on the space side, of a heat exchanger to perform heat exchange.
FIG. 7 is a cross-sectional view illustrating a state in which projecting portions are provided at both molded bodies of a heat exchanger to perform heat exchange, this configuration being a variation example of that depicted in FIG. 5.
FIG. 8 is a cross-sectional view illustrating a state in which projecting portions are provided at one molded body, on the electronic component side, of a heat exchanger to perform heat exchange.
FIG. 9 is a cross-sectional view illustrating a state in which convex projecting portions are provided at two molded bodies such as to obtain a meandering flow of heat medium, and heat exchange is performed, this configuration being a variation example of that depicted in FIG. 6.
FIG. 10 is a partial sectional view illustrating another structural example relating to the joining member of the heat exchanger 1.
FIG. 11 is a cross-sectional view of a configuration in which a heat exchange enhancing body is contained in the heat exchanger, the heat exchange enhancing body having a honeycomb structure.
FIG. 12 is a cross-sectional view of a configuration in which a heat exchange enhancing body is contained in the heat exchanger, the heat exchange enhancing body being a metal block body and having a structure in which one row of through holes is provided therein.
FIG. 13 is a cross-sectional view of a configuration in which a heat exchange enhancing body is contained in the heat exchanger, the heat exchange enhancing body being a metal block body and having a structure in which two rows of through holes are provided therein.
FIG. 14 is a cross-sectional view of a configuration in which a heat exchange enhancing body is contained in the heat exchanger, the heat exchange enhancing body having a meandering structure of a bent shape.
FIG. 15 is a partial view illustrating a variation example of the configuration depicted in FIG. 14 in which the bent portions of the heat exchange enhancing body are flattened.
FIG. 16 is a partial view illustrating a variation example of the configuration depicted in FIG. 14 in which step portions are provided on the bent shape of the heat exchange enhancing body.
FIG. 17 is a plan view illustrating the inflow/outflow state of the heat medium in the heat exchanger 1 containing a heat exchange enhancing body; FIG. 17(a) illustrates an example in which the inflow port and outflow port are provided in the direction crossing the flow direction of the heat medium 8; and FIG. 17(b) illustrates an example in which the inflow port and outflow port are provided in the same direction as the flow direction of the heat medium 8 of the heat exchanger 1.
FIG. 18 is a partial view illustrating a variation example of the configuration depicted in FIG. 17 in which the shape of the heat exchange enhancing bodies is changed to change the heat medium flow.

### BEST MODE FOR CARRYING OUT THE INVENTION

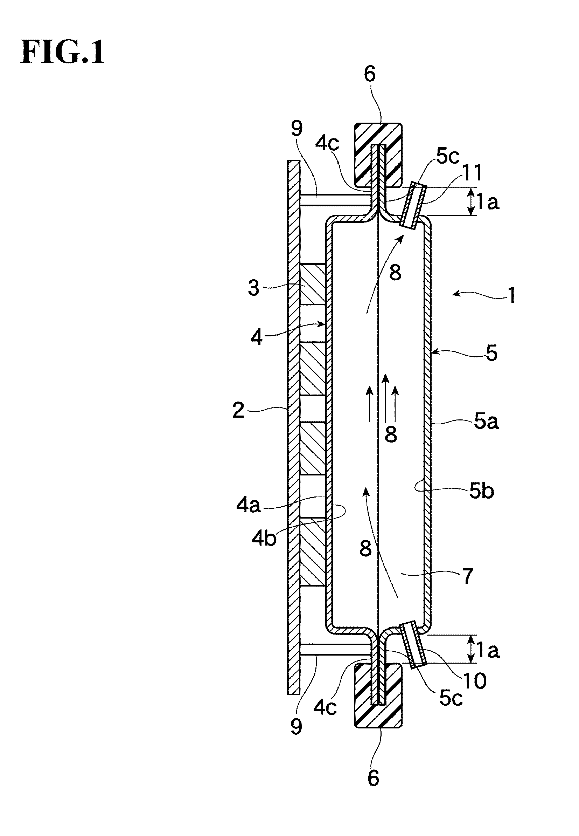

Embodiments of the present invention will be described hereinbelow with reference to the drawings. The structure depicted in FIG. 1 is a cross-sectional view illustrating a basic embodiment of the base body of the heat exchanger in accordance with the present invention, this view showing a state in which the heat exchanger is in contact with electronic components. Heat exchange apparatuses can be used for heating and cooling, but in the present embodiment, a heat exchanger used for cooling is explained. A heat exchanger 1 for cooling (referred to hereinbelow as "heat exchanger 1") is provided in contact with electronic components (heat exchange objects) 3, such as semiconductors, that are arranged and mounted on an electronic control circuit board 2 (referred to hereinbelow as "board 2") which is the object of heat exchange. The electronic components 3 which are the object of cooling are used mainly in control circuit apparatuses of automobiles.

The electronic components 3 are heat-generating sources and need to be cooled, since where a critical temperature is exceeded, the function thereof as electronic components is lost. In the heat exchanger 1 of the present embodiment, a first molded body 4 which is obtained by press-molding a thin aluminum alloy coil sheet and a second molded body 5 of the same structure are combined, and a joining member 6 which is a thermoplastic synthetic resin is formed by injection molding in the combination portions of the molded bodies. A heat medium 8 is circulated in an internal space 7 which is formed by combining the molded bodies, and heat exchange is performed. The heat medium in the present embodiment is cooling water.

The electronic components 3 are mainly cooled as a result of contact with an outer surface 4a of the first molded body 4, or an outer surface 5a of the second molded body 5, or both outer surfaces 4a, 5a. The thin aluminum alloy coil sheet which is used in the present embodiment is the same kind of thin aluminum alloy sheets used for beer cans or the like. This aluminum alloy coil sheet is a very thin sheet of a predetermined thickness (for example, 0.1 mm to 0.4 mm), and a very thin resin is covered on at least one surface thereof at a stage of coil-shaped material. On the inner and outer surface of a beer can, a coating is provided which has a thickness, for example, of about 4 µm on the inner surface and 4 µm to 10 µm (including the thickness of a paint) on the outer surface.

The resin coating film is typically a monolayer or multilayer laminated film. As for the resin type, for example, polypropylene (PP) is used. PP has a high melting point, a high thermal deformation temperature, high resistance to water boiling temperature, and a certain luster, and is suitable for forming transparent films. Furthermore, it is harder than polyethylene terephthalate (PET). However, the type of the coated resin is not limited to polypropylene (PP), and other resins, such as polyethylene terephthalate (PET), may be also used. The first molded body 4 and the second molded body 5 are obtained by press-molding a flat material for molded bodies (thin metal sheets) obtained by cutting the aluminum alloy coil sheet to predetermined shape and dimensions.

The thickness of the aluminum alloy coil sheet should be determined with consideration for the internal pressure, durability, and bendability, and it may be 0.1 mm to 0.8 mm, preferably 0.3 mm to 0.8 mm, and more preferably 0.3 mm to 0.5 mm. For example, when the internal pressure is 0.6 Mpa to 1 Mpa, the thickness may be 0.3 mm to 0.5 mm. The first molded body 4 is constituted by edge portions 4c formed at the periphery, and a recess, in the cross-sectional view (a protrusion when viewed from the other side), which is molded by press-molding between the edge portion 4c and the edge portion 4c. Likewise, the second molded body 5 is constituted by edge portions 5c formed at the periphery, and a recess, in the cross-sectional view (a protrusion when viewed from the other side), between the edge portion 5c and the edge portion 5c.

The recesses are molded by press-molding. The base body of the heat exchanger 1 constituted by the molded body 4 and the second molded body 5 is constructed by abutting the edge portions 4c and the edge portions 5c in a state in which the first molded body 4 and the second molded body 5 are combined such that the recess molded in the first molded body 4 and the recess molded in the second molded body 5 face each other. Alternatively, the base body of the heat exchanger 1 is obtained by combining the first molded body 4 and the second molded body 5 such that the inner surface 4b and the inner surface 5b face each other. The inner surfaces 4b, 5b are resin-coated surfaces, and those resin-coated surfaces are obtained by coating the surface of the aluminum alloy with the resin. The resin-coated surfaces prevent the material (aluminum alloy) of the first molded body 4 and the second molded body 5 from aging corrosion caused by the heat medium 8 flowing into the heat exchanger and also prevent the heat medium 8 from degradation during the use.

Therefore, the resin-coated surface prevents the material from erosion even when a heat medium such a non-freezing liquid is used, and demonstrates excellent gas barrier effect. The material of the first molded body 4 and the second molded body 5 which is coated with the resin can be performed to press working which is plastic processing. The resin-coated surface of the edge portion 4c of the first molded body 4 and the resin-coated surface of the edge portion 5c of the second molded body 5 are performed to hot press working after the inner surface 4b of the edge portion 4c and the inner surface 5b of the edge portion 5c have been abutted against each other. As a consequence, the resins forming the resin-coated surfaces are thermally fused. As a result of the resin-coated surface of the inner surface 4b of the edge portion 4c and the resin-coated surface of the inner surface 5b of the edge portion 5c being thermally fused, the resin-coated surfaces are brought into intimate contact with each other, and the heat medium 8 contained inside the space 7 is prevented from leaking to the outside of the heat exchanger 1 from the portions of such intimate contact. From the standpoint of the manufacturing process, this thermal fusion can be also considered as provisional joining.

In an example of processing a beer can, the coil sheet therefor is processed into a can shape by DI molding (drawing and ironing) and a beer can is manufactured. Thus, the material is very thin, has properties suitable for DI molding, and can be press-molded while maintaining the thickness. For example, Patent Document 4 discloses an example of an aluminum alloy suitable for a DI can or bottle can which ensures moldability and suppresses strength reduction after coating with a resin to a minimum.

It is preferred that a metal with such capabilities be used. For example, a H19-tempered 3004-H19 alloy (see "JIS H 4000" stipulated by Japanese Industrial Standard) which is used as a beer can body material and processed to a predetermined thickness (for example, 0.3 mm) is preferred. The embodiment of the heat exchanger 1 which uses the above-described material is further described hereinbelow. In addition to the heat exchanger 1, a heat exchange apparatus is also provided with, for example, a heat medium circulation pump, a circulation circuit piping, and a control device, which are not depicted in the drawings. As mentioned hereinabove, the heat exchanger 1 is basically constituted by the first molded body 4 and the second molded body 5, which are two molded bodies. The space 7 is created inside the heat exchanger by combining the two molded bodies 4, 5, in which the recesses have been molded, such that the inner surfaces 4b, 5b face each other.

The internal space 7 is a flow channel for the heat medium 8, and the inner surfaces 4b, 5b are resin-coated surfaces which are coated with the resin. Therefore, when the two molded bodies 4, 5 are combined, the edge portion 4c of the first molded body 4 and the edge portion 5c of the second molded body 5 abut against each other. Since the abutting edge portions 4c, 5c are coated with the resin on the inner surfaces 4b, 5b, the coated resins are fused together when hot press working is performed, and the inner surface 4b of the edge portion 4c and the inner surface 5b of the edge portion 5c can be brought into perfect intimate contact with each other.

Thus, the thermally fused portion serves as a first seal that prevents the heat medium 8 from leaking from the space 7 to the outside of the heat exchanger 1 between the edge portion 4c and the edge portion 5c, thereby making it possible to seal the space 7. The outer surfaces 4a, 5a of the recesses are in contact with the electronic components 3, and the thickness of the two molded bodies 4, 5 is so thin that the bodies can be bent easily by the inner pressure of the heat medium 8. As a result, a structure is obtained which can be easily flexurally deformed.

Peripheral shapes of the edge portions 4c, 5c of the two molded bodies 4, 5, which have been combined together are rectangular shape to match the shape of the board 2 where the electronic component 3 are arranged. The outer surface 4a of the edge portion 4c and the outer surface 5a of the edge portion 5c are not coated with the resin. Further, the outer surface 4a of the edge portion 4c and the outer surface 5a of the edge portion 5c are performed to ultrafine surface treatment to form a fine uneven surface. This treatment is performed in order to increase the adhesion strength of the outer surface 4a of the edge section 4c and the outer surface 5a of the edge portion 5c to the joining member 6.

The ultrafine treatment is performed by a well-known method, but the essence thereof is described hereinbelow to facilitate the understanding of the present invention. Three conditions are associated with the treatment of the metal alloy surface in the present context. The first condition is that a rough surface is obtained by a chemical etching method such that a relief height difference measured for depressions and protrusions with a peak-valley average spacing (RSm) having a period of 1 µm to 10 µm is less than about half of the period, that is, the maximum roughness height (Rz) is 0.2 µm to 5 µm. Rephrasing, a surface with a micron-order roughness is obtained.

The second condition is that an ultrafine uneven surface with a period equal to or greater than 10 nm, preferably about 50 nm, is present on the inner wall surface of the depressions forming the aforementioned rough surface. The third condition is that the surface of such a complex configuration is a ceramic material, more specifically, a metal oxide layer which is thicker than the natural oxidation layer on the metal alloy species that inherently have poor corrosion resistance, and, a thin layer of a metal oxide or metal phosphorus oxide produced by chemical conversion treatment on the metal alloy species that inherently have poor corrosion resistance.

Thus, (1) a surface with large depressions and protrusions of a micron order is obtained by certain chemical processing for a metal alloy. Then, in greater detail, (2) ultrafine depressions and protrusions with a period equal to or greater than 10 nm are provided on the inner wall surface of at least the large depressions of a micron order, and then (3) the metal alloy surface having such ultrafine depressions and protrusions and also depressions and protrusions of a micron-order which are larger than the ultrafine depressions and protrusions are themselves coated with a thin ceramic material.

In a specific example of such surface treatment, for example, the surface is chemically etched to a roughness of 0.5 µm to 10 µm, this surface is covered with a ultrafine uneven surface with an irregular period of 5 nm to 500 nm, and the resultant surface is covered with a thin layer of a metal oxide or metal phosphorus oxide. Such a treatment enables strong integration of the metal with the resin. Since such surface treatment is described in detail in the aforementioned Patent Documents 6 and 7, detailed explanation thereof is herein omitted.

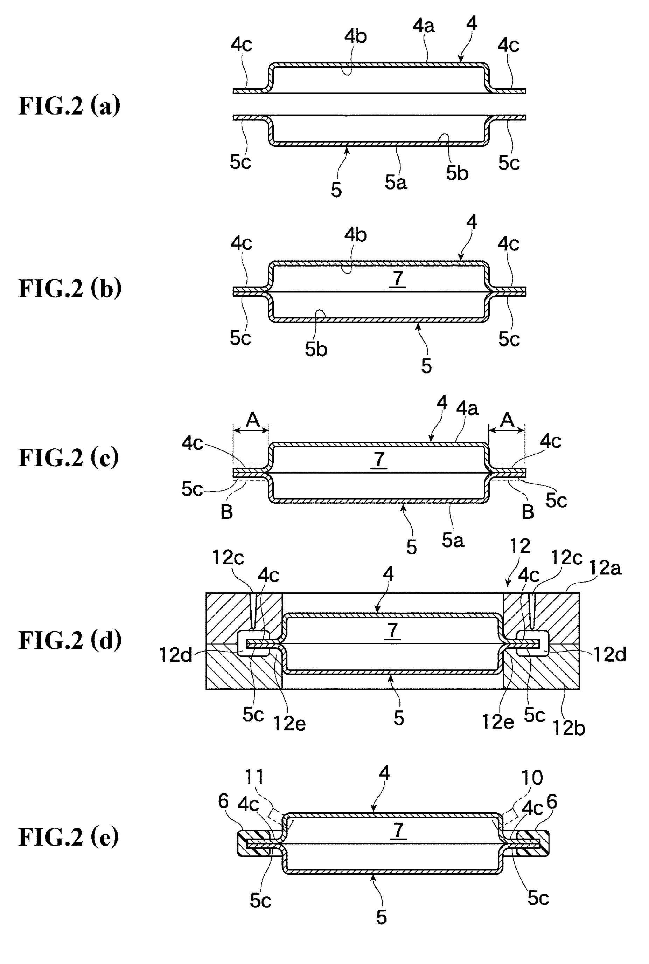

The edge portions 4c, 5c which have been treated to obtain the fine uneven surface are abutted against each other, inserted in a die in a state in which the resin-coated surface of the inner surface 4b and the resin-coated surface of the inner surface 5b are thermally fused, the resin joining member 6 is formed by injection molding at the edge portions 4c, 5c, and the base body shape of the unitary heat exchanger 1 is obtained. As depicted in the figure, the joining member 6 is configured such that the regions (regions separated by 1a from the end surfaces of the recesses of the molded bodies 4, 5) located outside of a portion 12e (see FIG. 2(d)) representing the control portion of the die, that is, the edge portions 4c, 5c on the perimeter of the two molded bodies 4, 5, are surrounded by the joining member in an endless manner. The joining member 6 covers and surrounds the edge portions 4c, 5c of the two molded bodies 4, 5 in a straddling manner.

As a result, a second seal is produced in which the periphery of the edge portions 4c, 5c of the two molded bodies 4, 5 is in a completely sealed state, and this seal in combination with the first seal configured by thermally fusing the resin-coated surfaces of the inner surfaces 4b, 5b makes it possible to ensure double sealing of the space 7. Further, since the periphery of the two molded bodies 4, 5 is completely sealed, the heat medium 8 can be prevented from leaking from the joining member 6 to the outside of the heat exchanger 1 regardless of the adverse environment in which the heat medium 8 of the heat exchanger 1 may be present. The joining member 6 combines together and joins the two molded bodies 4, 5 in the above-described manner, and it is preferred that the resin body thereof be obtained by injection molding of a crystalline thermoplastic resin composition (referred to hereinbelow as "resin composition") preferably comprising a polybutylene terephthalate resin (PBT), a polyphenylene sulfide resin (PPS), or a polyamide resin (Nylon 6, Nylon 66, etc.) as a main component.

As a result, the outer surface 4a of the edge portion 4c and the outer surface 5a of the edge portion 5c of the two molded bodies 4, 5 made from an aluminum alloy, and the joining member 6, which is a resin body, are strongly integrated and joined together. Further, where the joining member 6 is molded, even when burrs, or the like, are formed during molding at the edge portions 4c, 5c of the two molded bodies 4, 5, which are made from a metal, it is not necessary to remove the burrs, and the joining member 6 can be molded while the burrs are present. The possibility to omit the deburring makes a significant contribution to the reduction in the number of processing steps, in particular, in the case of mass production.

The structure in FIG. 1 illustrates a heat exchange state in which the unitary heat exchanger 1 is brought into contact with the electronic components 3. This configuration assumes that a plurality of electronic component 3 has the same height, but in some cases, certain height fluctuations, such as an error in the height or attachment of the electronic components 3, can occur when the electronic components are arranged on the board 2. In such cases, since the aluminum alloy thickness of the two molded bodies 4, 5 are extremely thin, the pressure per unit surface area is constant due to the Pascal's principle, and the outer surfaces 4a, 5a are easily locally deformed, even when an error in the height or attachment of the electronic components 3 occurs, the outer surfaces are pressed into uniform intimate contact with the electronic components 3 by the pressure of the heat medium in the space 7. As a result, heat conduction efficiency can be increased.

Therefore, no spread in the contact state is caused by the electronic components 3, and the efficiency of heat exchange does not change depending on a region. Further, a structure is obtained in which rod-shaped support bodies 9 that support the edge portions 4c, 5c of the heat exchanger 1 are provided between the board 2 and the heat exchanger 1. The rod-shaped support bodies 9 are fixing means for positioning and fixing such as to prevent displacement even in the case of vibrations. The heat exchanger 1 can be integrally attached through the rod-shaped support bodies 9 to the board 2 where the electronic components 3 are arranged.

With fixing means such as the rod-shaped support bodies, a cooling space is ensured between the electronic components 3 and the heat exchanger 1. The heat medium 8 is supplied from a supply port 10 of the two molded bodies 4, 5, flows as depicted by an arrow (see FIG. 1), and is discharged from a discharge port 11 of the two molded bodies 4, 5. The supply port 10 and the discharge port 11 are constituted by pipe-shaped members. The temperature of the heat medium 8 discharged from the heat exchanger 1 has increased due to heat exchange with the electronic components 3, and the heat medium is cooled to a predetermined temperature by an external cooling apparatus (not depicted in the figure) and again returned for circulation in the heat exchanger 1.

The cooling temperature of the electronic components 3 is a predetermined set temperature, and temperature control of the heat medium 8 is performed according thereto. In the present embodiment, the set temperature is equal to or less than 70°C. The heat medium 8 is cooling water, but when the heat exchanger is to be used in cold climates, the cooling water is a non-freezing liquid. The cooling water in this case is preferably, for example, water including an ethyleneglycol-type additive. Ethylene glycol is one of the main starting materials for polyethylene terephthalate (PET resin), but since it is easily soluble in water and has a low melting point, it is advantageous for a non-freezing liquid for automobiles.

FIG. 1 is a cross-sectional view illustrating the structure in which the heat exchanger 1 is brought into contact with the electronic components 3 in the above-described manner and attached so as to enable heat exchange. In this structural example, the electronic components 3 are brought into contact with the flat outer surface 4a of the first molded body 4 (one molded body). The heat medium 8 is supplied from the supply port 10, flows through the space 7, and is discharged from the discharge port 11, the space 7 serving as a flow channel therefor.

The plurality of electronic components 3 is not necessarily of the same height. In the conventional configurations, although tubular shapes of a certain thickness can be deformed, they are not deformed according to the height of each electronic component 3. In the present embodiment, the thickness of the two molded bodies 4, 5 is set to a predetermined level (for example, 0.1 mm or less). Therefore, even when there is an error in height or attachment, provided that it is in a predetermined range, the outer surface 4a is easily flexurally deformed, as mentioned hereinabove, due to the pressure, which is applied by the flowing heat medium 8, according to the individual electronic components 3. Furthermore, since the internal pressure of the heat medium 8 is the same in all locations according to the Pascal's principle, a constant contact pressure can be maintained for each electronic component, and therefore constant cooling capacity can be maintained. Thus, an intimate contact state can be realized for each electronic component 3 at all times.

A method for manufacturing a heat exchanger will be described hereinbelow in detail. FIG. 2 is an explanatory process diagram illustrating the manufacturing process. The two molded bodies 4, 5 obtained by press-molding, to a predetermined shape, a bendable thin metal sheet (flat material for molding) coated with a resin on one surface are arranged opposite each other as depicted in FIG. 2(a). In this state, the inner surfaces 4b, 5b of the recesses of the two molded bodies 4, 5 which have been press-molded are arranged opposite each other, and the inner surfaces 4b, 5b are resin-coated surfaces which have been coated with the resin.

Then, as depicted in FIG. 2(b), the two molded bodies 4, 5 are combined, and the resin-coated surfaces of the inner surfaces 4b, 5b of the edge portions 4c, 5c thereof are abutted against each other. In such an abutment state, the edge portions 4c, 5c are thermally fused by hot press working. As a result, the resin-coated surface of the edge portion 4c and the resin-coated surface of the edge portion 5c are brought into intimate contact with each other, and at the same time the interior portions of the two molded bodies 4, 5 form the space 7 surrounded by the inner surfaces 4b, 5b. At the inner surface 4b of the edge portion 4c and the inner surface 5b of the edge portion 5c, the resins coated thereon are thermally fused, a sealed state is assumed between the edge portion 4c and the edge portion 5c, and the space 7 becomes a flow channel for the heat medium 8. When the two molded bodies 4, 5 are combined, even when burrs, or the like, have occurred and the edge portions 4c, 5c have become irregular, no deburring treatment is performed.

Then, as depicted in FIG. 2(c), ultrafine processing treatment for forming a fine uneven surface is performed within a predetermined range of the outer surfaces 4a, 5a of the combined edge portions 4c, 5c. This treatment is performed in the range of portion "A" in FIG. 2(c) and in a treatment region denoted by the reference symbol "B" in FIG. 2(c). As mentioned hereinabove, the uneven surface is formed by a chemical etching method, and then a treatment is performed to obtain a ceramic surface on the ultrafine uneven surface with a period equal to or greater than 10 nm. Subsequently, the two molded bodies 4, 5 which have been performed to the ultrafine processing treatment and thermally fused together are inserted into a die 12 as depicted in FIG. 2 (d) .

The die 12 is constituted by an upper die 12a and a lower die 12b, and the two molded bodies 4, 5, are inserted across the two dies 12a, 12b. When the die 12 is closed, a cavity 12d for forming the joining member 6 is formed around the edge portions 4c, 5c. In the structure obtained, portions 12e of the control portions of the die 12a and the die 12b sandwich parts of the edge portions 4c, 5c on the recess side thereof. The structure is thus obtained in which the edge portions 4c, 5c, in the irregular state thereof, of the two molded bodies 4, 5 protrude into the cavity 12d. The two thermally-fused molded bodies 4, 5 are aligned, the die 12 is closed, and a resin composition is then injected into the cavity 12d through a gate 12c.

As mentioned hereinabove, in the present example, the resin composition is a resin comrising PBT or PPS as the main component. The resin composition injected into the cavity 12d sandwiches the periphery of the edge portions 4c, 5c and seals the space 7. Then, after the resin composition has solidified, the die 12 is opened and the two integrated molded bodies 4, 5 including the solidified joining member 6 are removed from the die. As depicted in FIG. 2(e), at this stage, the joining member 6 obtained by solidifying the resin composition on the two molded bodies 4, 5 is provided such as to straddle the edge portions 4c, 5c, and an integral joining and adhered base body of the heat exchanger 1 is obtained.

The supply port 10 and the discharge port 11 which are essential to the functions of the heat exchanger 1 are attached to the base body so as to communicate with the space 7, and the manufacture of the heat exchanger 1 in the basic form thereof is thus completed. The forms of the supply port 10 and the discharge port 11 are not limited. In a simple example, a method can be used by which holes are drilled at appropriate locations, but the present embodiment is explained by providing a pipe.

The supply port 10 and the discharge port 11 may be provided at a stage of the process before or after the stage at which the two molded bodies 4, 5 are combined together. In this case, the die structure to be used at the injection molding stage, which is the subsequent process, needs to be such as to avoid the interference with the supply port 10 and the discharge port 11. Further, where the supply port 10 and the discharge port 11 can be provided on the flat portions on the two molded bodies 4, 5 on the outer surface 5a side, the supply port 10 and the discharge port 11 can be produced by only molding the respective regions at the press-molding stage by a method of partially projecting the regions in a pipe-like shape and forming holes in the end portions thereof.

The heat exchanger in accordance with the present invention is basically manufactured according to the method of the present embodiment, and other embodiment of the heat exchanger are explained hereinbelow as the cases of cooling in which electronic components are the heat exchange object. In the explanation of the other embodiments, the parts same as those of the above-described embodiment are assigned with the same reference numerals and the detailed explanation thereof is herein omitted.

### (Another Embodiment 1)

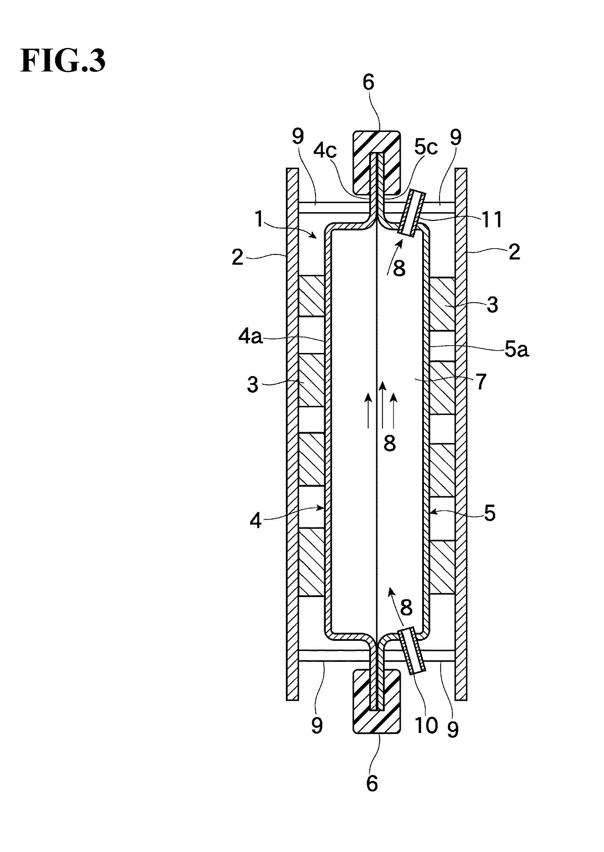

Another Embodiment 1 will be explained hereinbelow with reference to FIG. 3. The example depicted in FIG. 3 represents the structure depicted in FIG. 1 in which the electronic components 3 are also brought into contact with the outer surface 5a of the second molded body 5, and the electronic components 3 positioned at both sides of the heat exchanger 1 are cooled at the same time. In this case, the first molded body 4 and the second molded body 5 are under identical conditions. This is an example of a structure in which a plurality of electronic components 3 arranged on two boards 2 can be efficiently cooled with one heat exchanger 1. The first molded body 4 and the second molded body 5 at both sides of the heat exchanger 1 can be brought into contact with the electronic components 3 to cool the components.

### (Another Embodiment 2)

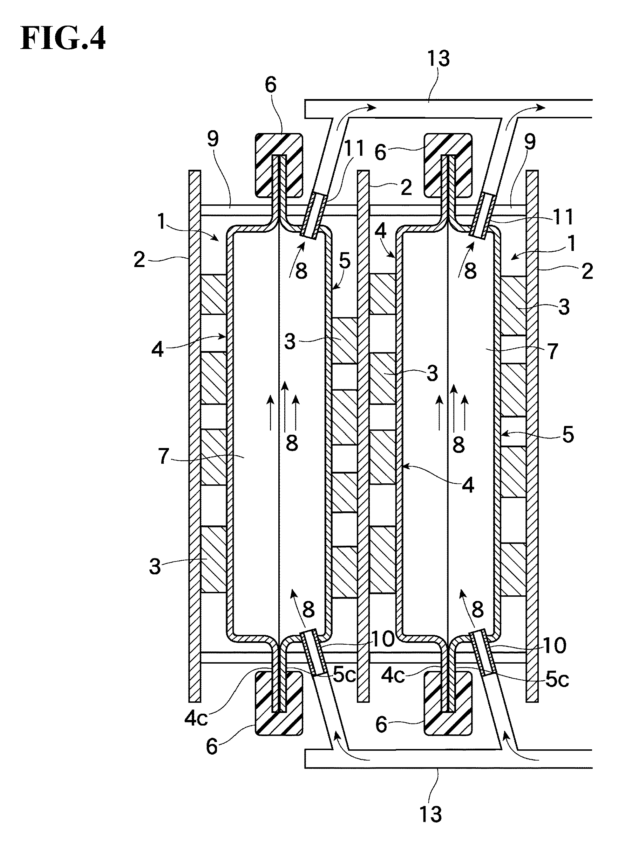

Another Embodiment 2 will be explained hereinbelow with reference to FIG. 4. In the structural example depicted in FIG. 4, a plurality of the heat exchangers 1 is arranged side by side to cool a plurality of the electronic components 3. This is an example of a structure in which the heat exchangers 1 are disposed between a plurality of the boards 2 to cool the electronic components 3 mounted on both surfaces of the plurality of the boards 2. In the figure, two heat exchangers 1 are depicted, but this number of the heat exchangers 1 is not limiting, and a plurality of the heat exchangers 1 may be stacked, if necessary, correspondingly to the plurality of the boards 2. The supply and discharge of the heat medium 8 in this case may be performed by providing conduits 13 is which the heat medium from the supply ports 10 and the heat medium from the supply ports 10 are collected, as depicted in the figure, and branching the supply and discharge to individual supply ports 10 and discharge ports 11 in the conduits 13 across the plurality of the heat exchangers 1.

### (Another Embodiment 3)

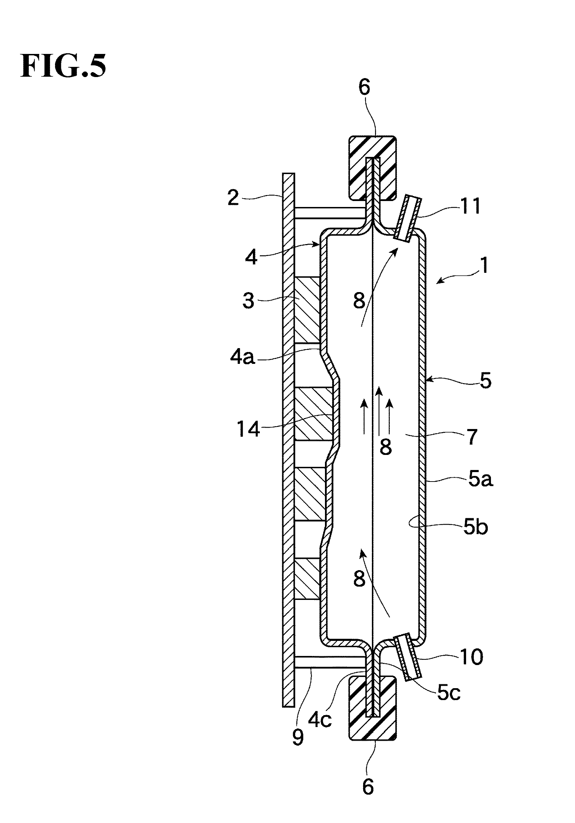

Another Embodiment 3 will be explained hereinbelow with reference to FIG. 5. In the structural example depicted in FIG. 5, a plurality of the electronic components 3 which is mounted on a board is designed to have different heights. In this case, with the above-described configuration having a single recess surface, flexural deformation along of the single recess surface is insufficient. Thus, with the outer surface shape which is a single flat shape, it is impossible to ensure intimate contact with the entire surface or substantially entire surface of all of the electronic components 3 which differ in height. In order to enable such intimate contact, shapes 4a of electronic component contact portions which are the regions where the electronic components 3 are in contact with the recess of the first molded body 4 are formed as stepped surfaces 14 providing for an uneven state matching the heights of the electronic components 3. This structural example is effective when the electronic components 3 are attached at random to the board 2.

The shape of the external surface of the first molded body 4 is determined by the die at the press working stage, and the uneven surface is formed in the press working according to the height and arrangement of the electronic components 3. As a result, even when the electronic components 3 differ from each other, that is, when the electronic components 3 differ in shape and height, both the outer surface 4a and the stepped surfaces 14 can be brought into intimate contact and cooling efficiency can be increased. In this case, even when it is necessary to cool the electronic components 3 with the second molded body 5, as depicted in FIGS. 3 and 4, the structure of the heat exchanger 1 adapted to a plurality of boards 2 and the electronic components 3 of different heights (this structure is not depicted in the figure) can be obtained by molding only the uneven surface, which is the same as that of the first molded body 4, that is, molding the stepped surface 14 by press working, at the electronic component contact portions of the recess of the second molded body 5.

### (Another Embodiment 4)

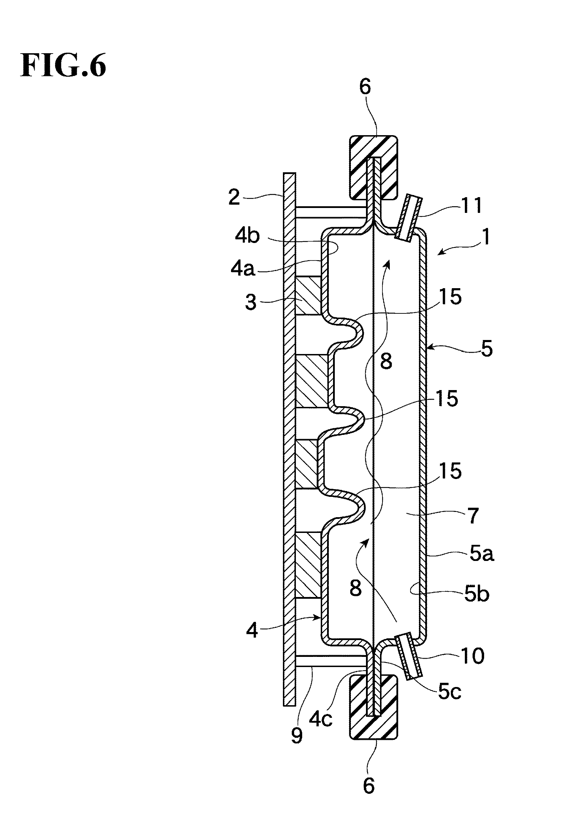

Another Embodiment 4 will be explained hereinbelow with reference to FIG. 6. In the structural example depicted in FIG. 6, parts of the shape of the electronic component contact portions of the recess of the first molded body 4 in the structure of Another Embodiment 3 (see FIG. 5) are projected in the form of ribs into the space 7. By providing projecting portions 15 of such protruding shape, it is possible to increase the heat conduction area, cool the environment close to the electronic components, and increase the heat exchange efficiency per unit surface area and unit volume, thereby increasing the cooling effect. Thus, as the cooling area of the outer surface 4a of the first molded body 4 provided with the projecting portions 15 is expanded, the heat medium 8 flows over the projecting portions 15, thereby making it possible to maintain the effective cooling state with respect to the electronic components 3. The projecting portions 15 are shaped only by press working. Therefore, no parts are required for forming the protruding shape for generating a turbulence, and no parts relating to such an effect need to be inserted into the space 7.

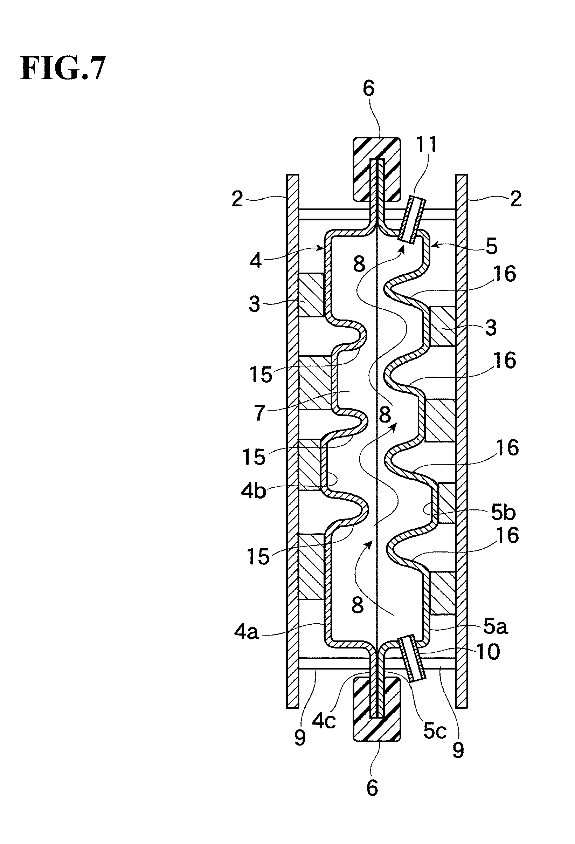

FIG. 7 illustrates an example of a structure in which a structure similar to that of the first molded body 4 depicted in FIG. 6 is also provided on the second molded body 5. Thus, at the second molded body 5, parts of the shape of the electronic component contact portions of the recess of the second molded body 5 are made to project to the space 7 side in the same manner as at the first molded body 4, and projecting portions 16 are formed by press working. The press working of those projecting portions 15, 16 is performed within a range not exceeding the combination surfaces of the two molded bodies. FIG. 7 illustrates the case in which the arrangements of the electronic components 3 on the first molded body 4 and the second molded body 5 are shifted alternately in a zigzag manner, and since the flow of the heat medium 8 in this case takes a somewhat longer path by flowing in a meandering fashion at the first molded body 4 and the second molded body 5 side, the cooling effect can be further increased.

### (Another Embodiment 5)

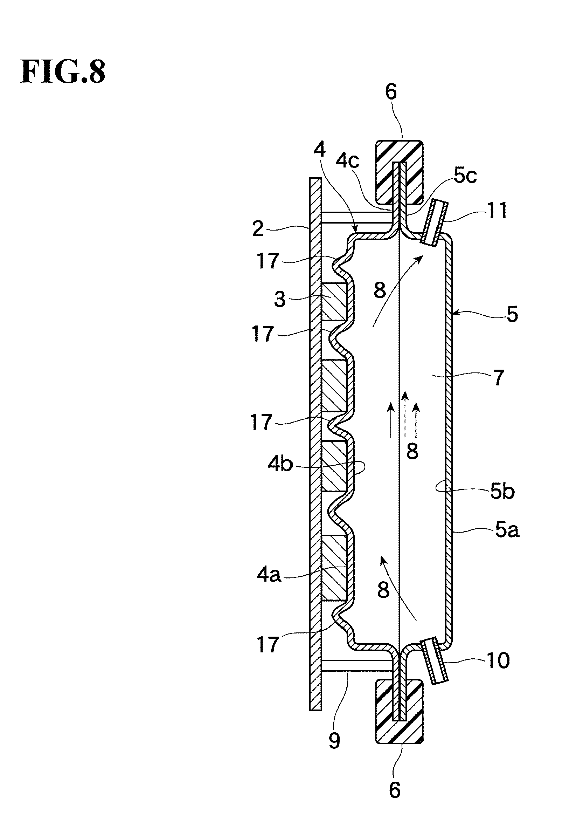

Another Embodiment 5 will be explained hereinbelow with reference to FIG. 8.

In the structural example depicted in FIG. 8, projecting portions 17 are provided such that parts of the electronic component contact portions of the recess in Another Embodiment 4 (see FIGS. 6 and 7) project from beyond the contact surface of the electronic components 3 towards the electronic component 3 side. In the structure of this example, the side surfaces of the electronic components 3 can be also cooled, and the cooling effect can be further increased. It goes without saying that the same structure can be also implemented on the second molded body 5 (such configuration is not depicted in the figures).

### (Another Embodiment 6)

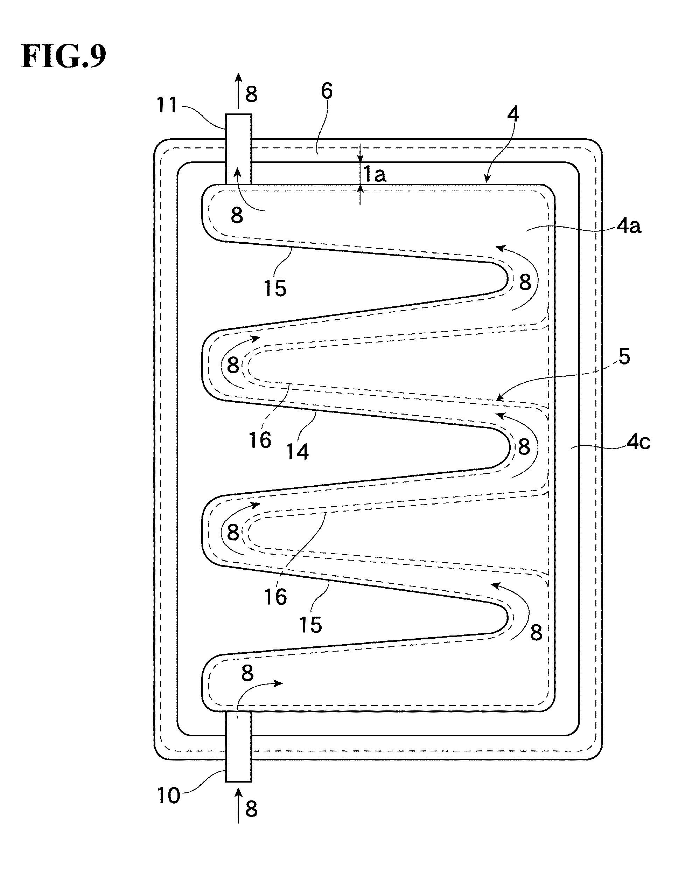

Another Embodiment 6 will be explained hereinbelow with reference to FIG. 9. FIG. 9 is a plan view of the heat exchanger 1 that illustrates a structural example in which the flow of the heat medium 8 is caused to meander. This is a variation example of the case in which the projecting portions 15, 16 are provided on the space 7 side, as in FIGS. 6 and 7, but in this structure, portions of linear shape are alternately added to the projecting portions 15, 16 and the heat medium 8 is caused to flow from the supply port 10 to the discharge port 11 while being forced to meander in the left-right direction. The length of the flow of the heat medium 8 is thus increased, the cooling function of the heat medium 8 is effectively used, and heat exchange between the electronic components 3 and the periphery thereof can be further increased. However, the application of Another Embodiment 6 is limited because the positions and arrangement range of the outer surfaces 4a, 5a is restricted and controlled by the arrangement of the electronic components 3.

### (Another Embodiment 7)

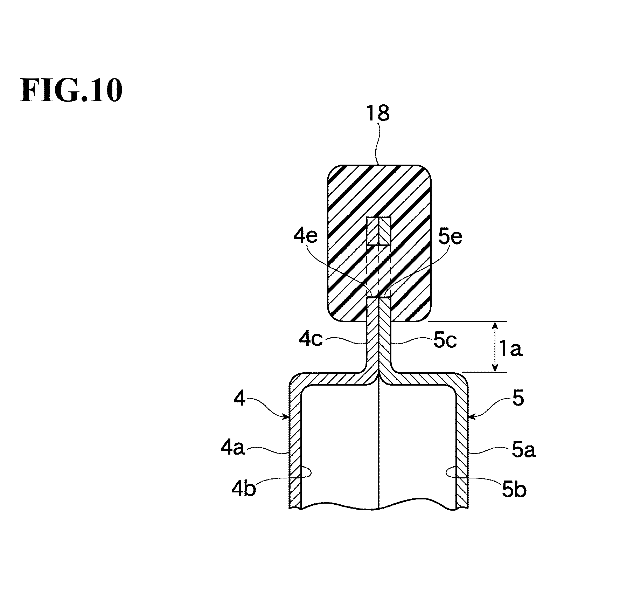

Another Embodiment 7 will be explained hereinbelow with reference to FIG. 10. FIG. 10 is a partial cross-sectional view illustrating another structural example relating to the joining member of the heat exchanger 1. In this example, the joining member is structurally reinforced. Thus, as depicted in the figure, before the resin composition is injected, through holes 4e, 5e are provided in a plurality of locations of the edge portions 4c, 5c of the two molded bodies 4, 5. With such a configuration, the resin composition injected in the course of injection molding passes through and fills the through holes 4e, 5e. Therefore, the joining member 18 is formed in an integral joining state in which the edge portions 4c, 5c are inserted therein. As a result, a structure is obtained in which the joining member 18 is prevented from breaking, such as peeling, even under the effect of vibrations, or the like, and is not separated or detached from the edge portions 4c, 5c of the two molded bodies 4, 5, unless as a physical force causing a fracture acts upon the joining member 18.

The examples illustrating the cooling effect of the heat exchanger 1 and the joining state thereof, which are explained hereinabove, are focused on the examples of shape deformation of the heat exchanger 1 which is brought into contact with and caused to cool the electronic components 3. Structural examples in which the cooling efficiency of the heat exchanger 1 is further increased are explained hereinbelow. In the structural examples of the following embodiments, heat exchange enhancing bodies produced from materials, such as metals, that enhance heat exchange are inserted into the space 7 of the heat exchanger 1. The structural examples explained hereinbelow represent techniques that can be also applied to the above-described other embodiments.

### (Another Embodiment 8)

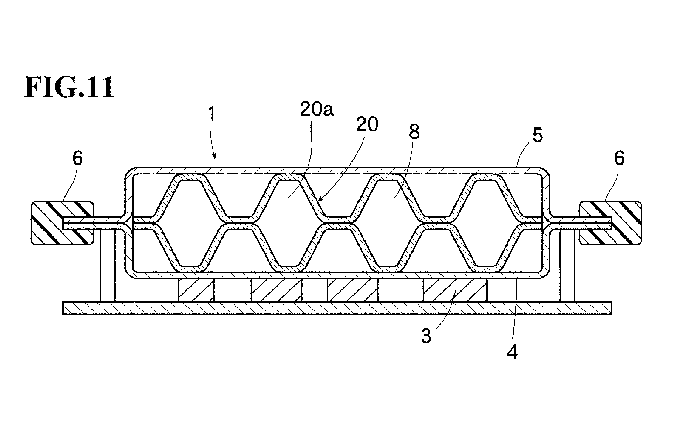

FIG. 11 illustrates a structure in which a heat exchange enhancing body 20 formed in an insertable shape is inserted into the space 7 of the heat exchanger 1. The heat exchange enhancing body 20 is a structural body of a honeycomb structure. The heat medium 8 flows through the spaces of the honeycomb structure, the heat from the electronic components 3 is absorbed through the heat exchange enhancing body 20 as the heat medium flows, thereby cooling the electronic components, and the heat exchange is enhanced. Since the heat medium 8 is brought into contact with the wall surface of the honeycomb structure, a large amount of heat is absorbed and released and the heat exchange efficiency is increased. At the same time, heat exchange enhancing body 20 controls the direction and flow rate of the flow of the heat medium 8 in order to increase the heat exchange efficiency.

The honeycomb structure is obtained by superimposing two configurations obtained by bending thin sheets of an aluminum alloy, or the like, and has the so-called beehive shape with a hexagonal cross section. Where such a structure is inserted into the heat exchanger 1, the section modulus of the heat exchanger 1 is improved and a strong configuration capable of withstanding stresses such as bending stresses is obtained. At the same time, the heat medium 8 is caused to pass in spaces 20a having a hexagonal shape, and the heat exchange efficiency is increased. Since the honeycomb structure has a large area of contact with the heat medium 8, heat conduction from the heat medium 8 is increased and heat exchange is further enhanced as compared with the above-described examples configured only of the space.

### (Another Embodiment 9)

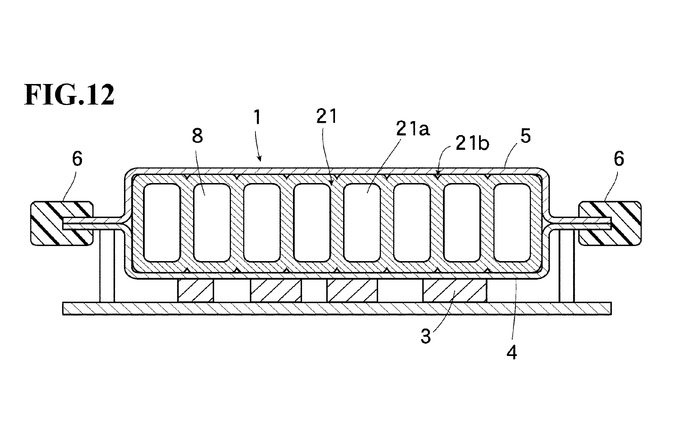

FIG. 12 illustrates an example in which a heat exchange enhancing body 21 in the form of a metal block body having a plurality of through holes 21a is inserted into the space 7. In this example, the heat medium 8 is caused to flow through the through holes 21a. As a result, the heat medium 8 absorbs heat in the flow-through process, the heat exchange is enhanced, and the heat exchange efficiency is increased. In the present example, the through holes 21a have a rectangular cross-sectional shape, and a plurality of holes is arranged along a straight line. In this case, when the heat medium 8 passes through the holes, the area of contact with the walls of the through holes 21a is also increased. Therefore, heat absorption is increased and, in the same manner as described hereinabove, the heat exchange is enhanced and the cooling efficiency is increased. Further, since depression-shaped portions 21b which are relief portions are provided in wall regions of the heat exchange enhancing body between the heat exchange enhancing body and the main body of the heat exchanger 1, a constant thickness is maintained when the heat exchange enhancing body 21 is molded and the deformation at the time of extrusion molding is small.

The heat exchange enhancing body 21 in the form of a metal block is molded by extrusion molding an aluminum alloy, and the molding can be performed to obtain the desired wall thickness between the through holes 21a. The metal block is provided with a wall surface 21b which is a wall surface in a wall region between the metal block and the main body of the heat exchanger 1. As a result, deformation in the production process can be prevented, the area of contact with the heat medium 8 can be ensured, and smooth heat exchange can be performed. The through holes 21a depicted in the figure have a rectangular cross-sectional shape, but they obviously may have another cross-sectional shape, such as round or elliptical shape.

### (Another Embodiment 10)

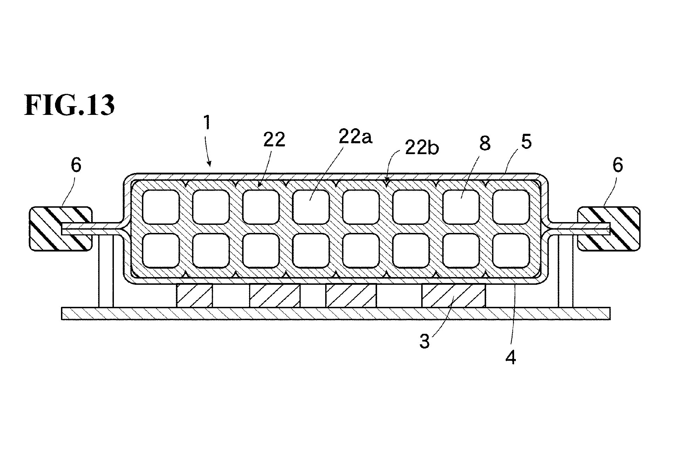

FIG. 13 depicts another embodiment illustrating a variation example of the configuration depicted in FIG. 12. In this example, through holes 22a of a heat exchange enhancing body 22 constituted by a metal block are arranged in two stages. The number of through holes 22a is increased, and the area of contact with the heat medium 8 is increased accordingly by comparison with the above-described case of a single-stage arrangement. Therefore, the heat exchange is further enhanced and the heat exchange efficiency is increased. The production of the configuration in which the through holes 22a of the heat exchange enhancing body 22 are arranged in multiple (two or more) layers, is restricted due to structural limitations placed on the die when the molding is performed by an extrusion molding method. Such a limitation is particularly significant in the case of a heat exchanger of a small shape, and a design change, such as a change in the shape of the through holes 22a, should be considered. The feature of providing the depression-shaped portions 22b which are relief portions in wall regions between the heat exchange enhancing body and the main body of the heat exchanger 1 is the same as in the above-described example.

### (Another Embodiment 11)

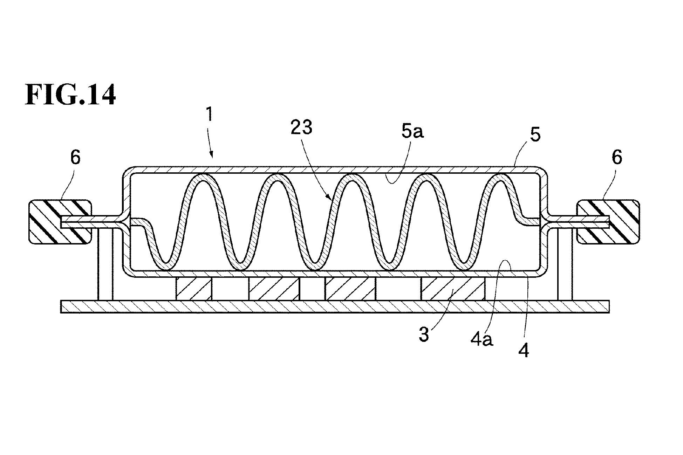

FIG. 14 illustrates an example of a heat exchange enhancing body 23 of a meandering form which is obtained by wave-like bending and deforming a thin aluminum alloy sheet. This simplified structure has a meandering shape obtained by bending a single thin sheet. With this bent form, a structure is obtained in which the bent portions are brought into contact with the inner surfaces 4b, 5b of the molded bodies 4, 5 in order to improve thermal conductivity, and a spot or surface contact with the heat exchanger 1 is realized. The heat medium 8 flows through the spaces in the wavy sheet and the heat exchange is enhanced.

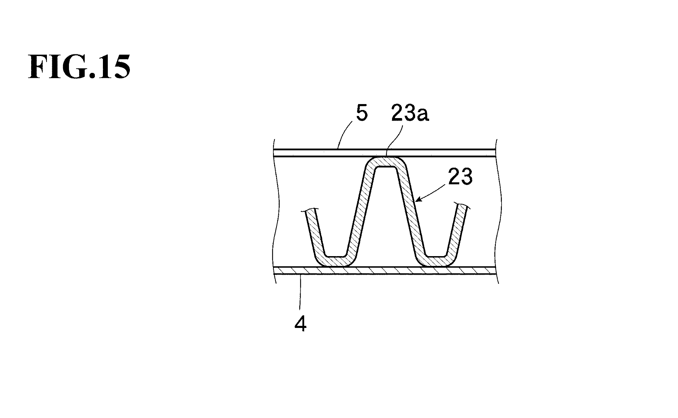

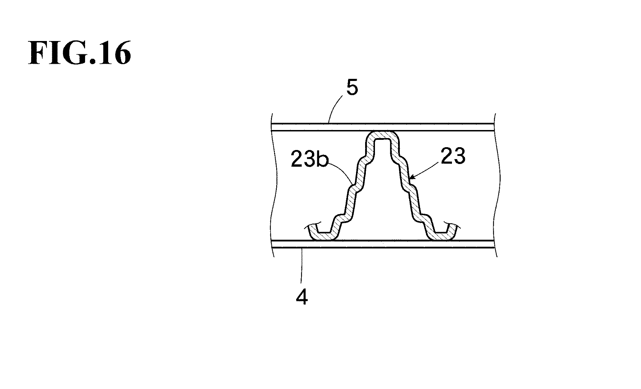

Such a structure can be manufactured at a low cost. In addition, where the meandering spacing is narrowed, the area of contact with the heat medium 8 is increased, the heat exchange is enhanced, and the heat exchange effect can be improved. Such a structure presumes that the heat exchanger 1 is a thin metal sheet and that the joint is the resin joint 6. The figure illustrates a simple structure, but the shape of the heat exchange enhancing body 23 may be different. For example, as depicted partially in FIG. 15, the regions of the heat exchange enhancing body that are in contact with the inner surfaces 4b, 5b may be flat portions 23a. Alternatively, as depicted partially in FIG. 16, a heat exchange enhancing body of a wavy shape which is provided with steps 23b may be used.

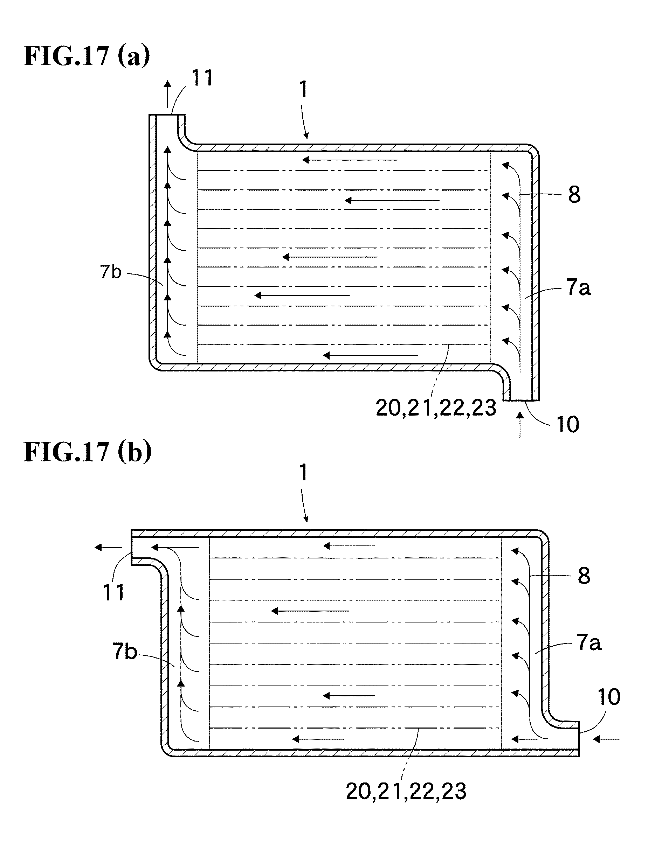

FIGS. 17(a) and 17(b) illustrate the flow of the heat medium 8 in the heat exchanger 1 in the other embodiments depicted in abovementioned FIGS. 11 to 16. FIG. 17(a) illustrates the case in which the heat medium 8 is caused to flow in from the side surface of the heat exchanger 1 where the inflow port 10 and the outflow port 11 are disposed in the direction crossing the flow direction of the heat medium 8. Reservoir spaces 7a, 7b are arranged in the space 7 on the inflow port 10 and outflow port 11 sides. The heat medium 8 flows in from the inflow port 10, accumulates in the reservoir space 7a, then flows, while dispersing, in the directions shown by the arrows and flows into the heat exchange enhancing bodies 20, 21, 22, 23. Heat is absorbed through the heat exchange enhancing bodies 20, 21, 22, 23, the flows of the heat medium 8, which is in the heated state, merge in the reservoir space 7b on the outflow side, as shown by the arrows in the figure, and the heat medium is discharged to the outside through the outflow port 11.

FIG. 17(b) illustrates an example in which the directions of the inflow port 10 and the outflow port 11 of the heat medium 8 are changed. In this example, the heat medium flows in from the same direction as the flow direction of the heat medium 8 in the heat exchanger 1. In the same manner as described hereinabove, the heat medium 8 that has flown in from the inflow port 10 flows into the abovementioned heat exchange enhancing bodies 20, 21, 22, 23 in the directions shown by the arrows through the reservoir space 7a, the heat is absorbed, the flows of the heat medium 8, which is in the heated state, merge in the reservoir space 7b on the outflow side, as shown by the arrows in the figure, and the heat medium is discharged to the outside through the outflow port 11 in the same direction as the flow direction thereof.

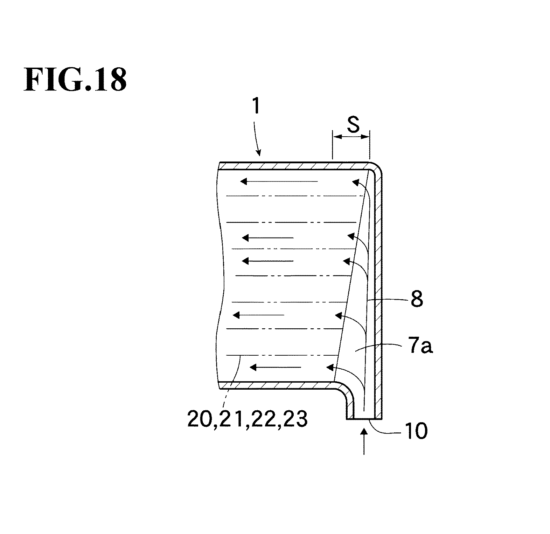

Thus, for example, the height, diameter, and shape of the heat exchange enhancing bodies are changed and controlled to obtain the uniform flow of the heat medium 8, or according to heat generation by individual electronic components, and the efficiency of heat exchange is increased. FIG. 18 is a partial view illustrating another embodiment corresponding to FIG. 17(a). In this example, uniform inflow of the heat medium 8 from the inflow port 10 with respect to the heat exchange enhancing bodies 20, 21, 22, 23 is ensured. Thus, in the reservoir space 7a of this structural example, the size of the reservoir space 7a on the deep side is made less than that on the front side of the inflow, and the inflow on the deep side is made uniform in the same manner as on the front side with respect to the heat exchange enhancing bodies. More specifically, as depicted in the figure, in this structure, the length of the heat exchange enhancing bodies 20, 21, 22, 23 on the deep side is made larger by the size S than that on the front side. By so improving, albeit to a small degree, the uniformity of flow of the heat medium 8 which is caused to flow into the reservoir space 7a, it is possible to enhance cooling and increase the cooling effect.

The embodiments of the present invention are explained hereinabove, but the present invention is not limited to those embodiments. It goes without saying that changes can be made without departing from the objective and essence of the present invention. For example, metals other than aluminum alloys, for example, copper, can be also used as the main constituent material of the heat exchanger, provided that they are metals in the form of thin sheets, have high corrosion resistance, can be press worked, and have adhesion to resins.

Further, only the cooling application of the heat exchanger is explained hereinabove in detail, but the heat exchanger can be also used when the heat medium is heating water and, for example, heating with a heating device is required. Furthermore, a structure is explained above in which heat exchange is performed by bringing the heat exchanger into direct contact with electronic components, but a structure in which a member with good thermal conductivity (for example, an insulating material, such as a ceramic, with good thermal conductivity) is interposed therebetween may be also used. The material of the heat exchange enhancing bodies 20, 21, 22, 23 is not limited to metals and may be a synthetic resin with high thermal conductivity which has a low material cost and ensures high productivity may be also used.

### EXPLANATION OF REFERENCE NUMERALS

- 1: heat exchanger
- 2: electronic control circuit board
- 3: electronic component (heat exchange object)
- 4: first molded body
- 5: second molded body
- 6: joining member
- 7: space
- 8: heat medium (cooling water)

## Claims

1. A heat exchanger for exchanging heat with a heat exchange object through a heat medium,
the heat exchanger comprising:
a first molded body which comprises a thin metal sheet that can be bent by an internal pressure of the heat medium, and which comprises an outer surface that can contact with the heat exchange object and an inner surface coated with a resin, and an edge portion formed on a periphery and a recess formed in a concave cross-sectional shape between the edge portions;
a second molded body which is a member facing the first molded body and combined therewith, comprises a thin metal sheet that can be bent by an internal pressure of the heat medium, and which comprises an outer surface (5a) that can contact with the heat exchange object and an inner surface coated with a resin, and an edge portion formed on a periphery and a recess formed in a concave cross-sectional shape between the edge portions;
a joining member which is provided to straddle the edge portion of the first molded body and the edge portion of the second molded body, which are abutted against each other, the joining member integrally joining the edge portion of the first molded body and the edge portion of the second molded body by performing injection molding using a thermoplastic resin composition on the outer surface of the edge portion of the first molded body and on the outer surface of the edge portion of the second molded body; and
a space as a fluid passage for the heat medium which is surrounded and formed by the first molded body and the second molded body which are integrally joined by the joining member, and a supply port and a discharge port, wherein
the inner surface of the edge portion of the first molded body and the inner surface of the edge portion of the second molded body are brought into intimate contact with each other by thermally fusing the resins coated thereupon, thereby sealing the space.

2. The heat exchanger according to claim 1, wherein the thin metal sheet is an aluminum alloy sheet of a predetermined thickness that is coated with the resin.

3. The heat exchanger according to claim 1, wherein
the heat exchange object is an electronic component installed on an electronic control circuit board of an automobile, and a main component of the heat medium is cooling water.

4. The heat exchanger according to claim 1, wherein
the outer surface of the first molded body and the outer surface of the second molded body, to which the thermoplastic resin composition is adhered by the injection molding, is performed to ultrafine processing to strengthen the adherence of the thermoplastic resin composition, and
the thermoplastic resin composition comprises one selected from a polybutylene terephthalate resin, a polyphenylene sulfide resin, and a polyamide resin as a main component.

5. The heat exchanger according to claim 1, wherein
projecting portions of protruding shapes that project to the space side are provided at parts of the shape of the recess in one or two selected from among the first molded body and the second molded body to cause the heat medium to meander.

6. The heat exchanger according to claim 1, wherein
projecting portions of protruding shapes that project to the electronic component side are provided at parts of the shape of the recess in one or two selected from among the first molded body and the second molded body.

7. The heat exchanger according to claim 1, wherein
parts of the shape of the recess are protruded and depressed and steps matching the height of the electronic components are provided in one or two selected from among the first molded body and the second molded body.

8. The heat exchanger according to claim 1, wherein
the bendable thin metal sheet is a metal sheet of an aluminum alloy with a thickness of 0.1 mm to 0.8 mm.

9. The heat exchanger according to claim 1, wherein
heat exchange enhancing bodies that are in surface contact with the first molded body and the second molded body and enhance heat exchange are enclosed in the space.

10. A method for manufacturing a heat exchanger for exchanging heat with a heat exchange object through a heat medium,
the method comprising:
a process for press-molding two thin bendable metal sheets coated with a resin on surfaces one side thereof into a first molded body and a second molded body, which have, respectively, outer surfaces that are to be in contact with the heat exchange objects and inner surfaces that are resin-coated surfaces which are coated with the resin, an edge portion formed on a periphery and a recess formed in a concave cross-sectional shape between the edge portions;
a process for combining the first molded body and the second molded body such that the inner surface of the former and the inner surface of the latter face each other, thereby forming a space that serves as a flow channel for the heat medium, and thermally fusing the resin-coated surface of the edge portion of the first molded body and the resin-coated surface of the edge portion of the second molded body by hot press working;
an injection molding process for inserting the first molded body and the second molded body, which are thermally fused, into a die, injecting a thermoplastic resin composition into cavities formed in regions of the edge portions, and forming a joining member that joins integrally the first molded body and the second molded body; and
a process for providing the first molded body and the second molded body, which are joined by the joining member, with a supply port and a discharge port communicating with the space.

11. The method for manufacturing a heat exchanger according to claim 10, wherein
the thin metal sheet is an aluminum alloy sheet of a predetermined thickness that is coated with the resin;
the thermoplastic resin composition comprises one selected from a polybutylene terephthalate resin, a polyphenylene sulfide resin, and a polyamide resin as a main component; and
the method comprises a process for performing the outer surface of the first molded body and the outer surface of the second molded body to ultrafine processing to strengthen the adherence of the thermoplastic resin composition before the injection molding.

12. The method for manufacturing a heat exchanger according to claim 10, wherein
the process for press-molding comprises a process for molding projecting portions that project in a protruding shape in parts of the shape of the recess of one or two selected from among the first molded body and the second molded body in order to cause the heat medium to meander.

13. The method for manufacturing a heat exchanger according to claim 10, wherein
the process for press-molding comprises a process for molding step shapes in parts of the shape of the recess of one or two selected from among the first molded body and the second molded body.
